# EUROPEAN PATENT APPLICATION

(11) **EP 4 474 906 A1**
(43) Date of publication of application: **11.12.2024**
(21) Application number: 23747139.6
(22) Date of filing: 30.01.2023
(51) Int. Cl.: G03F 1/29, G03F 1/32, G03F 1/54, G03F 1/74, G03F 1/80

(54) **PHASE SHIFT MASK AND METHOD FOR MANUFACTURING PHASE SHIFT MASK**

(30) Priority: 31.01.2022 JP 2022013549
(71) Applicant: Toppan Photomask Co., Ltd., Tokyo 108-0023 (JP)
(72) Inventor: YONEMARU Naoto, Tokyo 108-0023 (JP); KUROKI Kyoko, Tokyo 108-0023 (JP); KOJIMA Yosuke, Tokyo 108-0023 (JP)
(74) Representative: Hoffmann Eitle
(86) International application number: PCT/JP2023/002815
(87) International publication number: WO 2023/145929

(57) **Abstract**

There are provided a phase shift mask having a small number of haze defects, that is, a phase shift mask capable of sufficiently suppressing occurrence of haze, and a method for manufacturing the phase shift mask. A phase shift mask (100) according to the present embodiment is a phase shift mask having a circuit pattern by application of exposure light having a wavelength of 200 nm or less, the phase shift mask including a substrate (11), a phase shift film (12) that is formed on the substrate (11) and has a circuit pattern, and a protective film (13) that is formed on an upper surface (12t) and a side surface (12s) of the phase shift film (12), in which the phase shift film (12) enables adjustment of each of phase and transmittance with respect to the exposure light to be transmitted to a predetermined extent, the protective film (13) has a refractive index n in a range of 1.2 or more and 2.6 or less with respect to the exposure light and an attenuation coefficient k in a range of 0.0 or more and 0.4 or less, and in a case where a film thickness of the phase shift film (12) is denoted by d1 and a film thickness of the protective film (13) is denoted by d2, d2 is thinner than d1, and d2 is 15 nm or less.

## Description

### Technical Field

The present invention relates to a phase shift mask and a method for manufacturing a phase shift mask, which are used in the manufacture of a semiconductor device or the like.

### Background Art

Recently, in semiconductor processing, nanofabrication of a circuit pattern has been required particularly along with high integration of a large scale integrated circuit, and a demand for a nanofabrication technology of interconnection patterns or contact hole patterns configuring the circuit has increased. Therefore, as an exposure light source used for manufacturing semiconductor devices and the like, shifting to a shorter wavelength from a KrF excimer laser (wavelength: 248 nm) to an ArF excimer laser (wavelength: 193 nm) is underway.

In addition, as a mask for improving wafer transfer characteristics, for example, a phase shift mask is used. In the phase shift mask, both a phase difference between ArF excimer laser light that transmits through a transparent substrate and ArF excimer laser light that transmits through both the transparent substrate and a phase shift film (hereinafter, simply referred to as "phase difference") and a ratio of the amount of ArF excimer laser light that transmits through both the transparent substrate and the phase shift film to the amount of ArF excimer laser light that transmits through the transparent substrate (hereinafter, simply referred to as "transmittance") can be adjusted so that the phase difference becomes 180 degrees and the transmittance becomes 6%.

For example, a method is known, in which when a phase shift mask having a phase difference of 180 degrees is manufactured, the film thickness of a phase shift film is set such that the phase difference becomes about 177 degrees, then, a transparent substrate is processed about 3 nm while dry etching the phase shift film with a fluorine-based gas, and finally the phase difference is adjusted to about 180 degrees.

In a phase shift mask to which exposure light having a wavelength of 200 nm or less is applied, foreign matter called "haze" is gradually formed, grown, and visualized by exposure in the mask, and the mask cannot be used any longer in some cases. In particular, when the phase shift film is a film including silicon, a transition metal, and a light element such as oxygen or nitrogen, foreign matter may be formed on the phase shift film surface.

Technologies for suppressing the haze are described in, for example, PTLS 1 and 2.

However, in the technologies described in PTLS 1 and 2, the effect of suppressing the above-described haze may be insufficient.

### Citation List

### Patent Literatures

PTL 1: JP 2018-173621 A
PTL 2: JP 4579728 B

### Summary of Invention

### Technical Problem

The present invention has been made in view of the above circumstances, and an object thereof is to provide a phase shift mask having a small number of haze defects, that is, a phase shift mask capable of sufficiently suppressing the occurrence of haze, and a method for manufacturing the phase shift mask.

### Solution to Problem

The present invention has been made to solve the above-described problems, and an aspect of the present invention relates to a phase shift mask having a circuit pattern by application of exposure light having a wavelength of 200 nm or less, the phase shift mask including: a transparent substrate; a phase shift film that is formed on the transparent substrate and has a circuit pattern; and a gas permeation protective film that is formed on an upper surface and a side surface of the phase shift film, wherein the phase shift film enables adjustment of each of phase and transmittance with respect to the exposure light to be transmitted to a predetermined extent, the gas permeation protective film has a refractive index in a range of 1.2 or more and 2.6 or less with respect to the exposure light and an attenuation coefficient in a range of 0.0 or more and 0.4 or less, and in a case where a film thickness of the phase shift film is denoted by d1 and a film thickness of the gas permeation protective film is denoted by d2, d2 is thinner than d1, and d2 is 15 nm or less.

In addition, a method for manufacturing a phase shift mask according to an aspect of the present invention is a method for manufacturing the above-described phase shift mask, the method including: a step of forming a phase shift film on the transparent substrate; a step of forming a light shielding film on the phase shift film; a step of forming a resist pattern on the light shielding film formed on the phase shift film; a step of forming a pattern on the light shielding film by oxygen-containing chlorine-based etching after forming the resist pattern; a step of forming a pattern on the phase shift film by fluorine-based etching after forming the pattern on the light shielding film; a step of removing the resist pattern after forming the pattern on the phase shift film; a step of removing the light shielding film from the phase shift film on which the pattern is formed by oxygen-containing chlorine-based etching after removing the resist pattern; a step of performing a defect inspection after removing the resist pattern and before removing the light shielding film or after removing the light shielding film; a step of correcting the light shielding film or the phase shift film at a defective portion in a case where a defect is detected in the defect inspection; and a step of forming the gas permeation protective film on an upper surface and a side surface of the phase shift film on which the pattern is formed after the correction.

### Advantageous Effects of Invention

By using the phase shift mask according to one aspect of the present invention, the occurrence of haze on the mask can be sufficiently suppressed. Furthermore, by using the phase shift mask according to one aspect of the present invention, it is possible to suppress an increase in reflectivity on the surface of the phase shift mask, and it is possible to reduce the deterioration of exposure performance due to so-called flare.

### Brief Description of Drawings

FIG. 1 is a schematic cross-sectional view illustrating a configuration of a phase shift mask blank according to an embodiment of the present invention;
FIGS. 2A and 2B are a schematic cross-sectional views illustrating a configuration of a phase shift mask according to the embodiment of the present invention;
FIGS. 3A to 3G are a schematic cross-sectional views illustrating steps of manufacturing a phase shift mask using the phase shift mask blank according to the embodiment of the present invention;
FIG. 4 is a schematic cross-sectional view illustrating a configuration of a phase shift mask according to a modification example of the embodiment of the present invention;
FIGS. 5A and 5B are a schematic plan view and a schematic cross-sectional view illustrating a structure before a correction step of a phase shift mask according to an example of the present invention;
FIG. 6 is a schematic cross-sectional view illustrating the correction step of the phase shift mask according to the example of the present invention; and
FIGS. 7A and 7B are schematic plan view and a schematic cross-sectional view illustrating a structure after the correction step of the phase shift mask according to the example of the present invention.

### Description of Embodiments

The present inventors considered that, in a case where all of three elements of a configuration material of a phase shift film configuring a phase shift mask blank or a phase shift mask, water or an oxidative gas such as oxygen, and an exposure energy are not prepared, the occurrence of haze in the mask blank or the mask can be reduced, and configured a phase shift mask blank or a phase shift mask as follows. That is, a phase shift mask and a method for manufacturing the same according to the present embodiment are based on a technical idea of reducing the occurrence of haze by providing a gas permeation protective film (so-called gas barrier layer) on an upper surface and a side surface of a phase shift film having a circuit pattern (so-called a phase shift film pattern) so that an oxidative gas does not come into contact with a configuration material of the phase shift film.

Embodiments of the present invention will be described with reference to the following drawings. A schematic cross-sectional view does not exactly reflect an actual dimensional ratio or the number of patterns, and the digging amount of a transparent substrate or the damage amount of a film is not illustrated.

Examples of a preferable embodiment of a phase shift mask blank of the present invention include the following aspect.

### (Overall Configuration of Phase Shift Mask Blank)

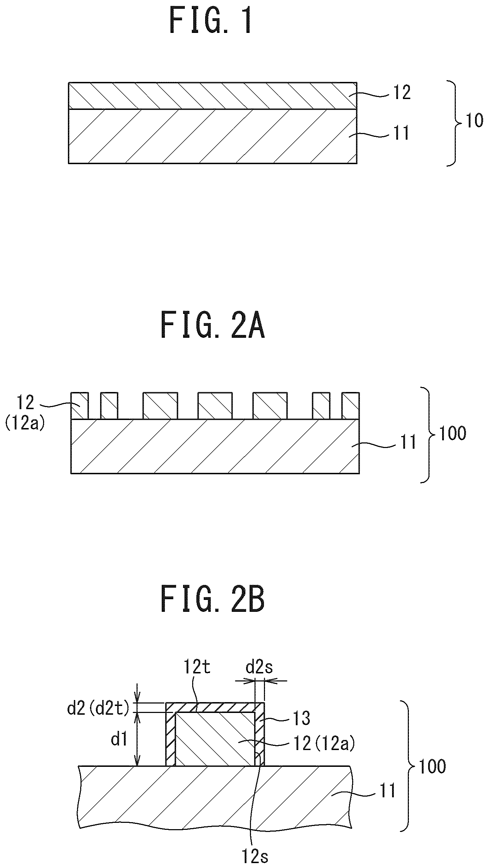

FIG. 1 is a schematic cross-sectional view illustrating a configuration of a phase shift mask blank according to an embodiment of the present invention. A phase shift mask blank 10 illustrated in FIG. 1 is a phase shift mask blank that is used for producing a phase shift mask to which exposure light having a wavelength of 200 nm or less is applied, the phase shift mask blank including: a substrate 11 that is transparent with respect to the exposure wavelength (hereinafter, also simply referred to as "substrate"); and a phase shift film 12 that is formed on the substrate 11. In addition, the phase shift film 12 has a function of enabling adjustment of each of phase and transmittance with respect to exposure light to be transmitted to a predetermined extent.

Hereinafter, each of the layers configuring the phase shift mask blank 10 according to the embodiment of the present invention will be described in detail.

### (Substrate)

The substrate 11 is not particularly limited. As the substrate 11, for example, quartz glass, CaF₂, or aluminosilicate glass is generally used.

### (Phase Shift Film)

The phase shift film 12 is formed on the substrate 11 with or without another film therebetween.

The phase shift film 12 is, for example, a film that has resistance to oxygen-containing chlorine-based etching (Cl/O-based) and can be etched by fluorine-based etching (F-based).

A value of the transmittance of the phase shift film 12 is in a range of, for example, 3% or more and 80% or less with respect to the transmittance of the substrate 11, and an optimum transmittance can be appropriately selected for a desired wafer pattern. In addition, a value of the phase difference of the phase shift film 12 is in a range of, for example, 160 degrees or more and 220 degrees or less and is more preferably in a range of 175 degrees or more and 190 degrees or less. That is, in the phase shift film 12, the transmittance with respect to the exposure light may be in a range of 3% or more and 80% or less, and the phase difference may be in a range of 160 degrees or more and 220 degrees or less. When the transmittance of the phase shift film 12 with respect to the exposure light is less than 3%, there may be a case where favorable exposure performance cannot be obtained. In addition, when the phase difference is in a range of 160 degrees or more and 220 degrees or less, required exposure performance can be easily maintained.

That is, the phase shift film 12 is a layer that enables adjustment of each of the phase and the transmittance with respect to the exposure light to be transmitted to a predetermined extent. Here, "adjustment of the phase" refers to, for example, inverting the phase. In addition, "transmittance" refers to the transmittance with respect to the exposure light.

The phase shift film 12 is, for example, a single-layer film that contains silicon and contains at least one selected from a transition metal, nitrogen, oxygen, and carbon, a multi-layer film or a graded film thereof, and a layer where the transmittance and the phase difference with respect to the exposure wavelength are adjusted by appropriately selecting a composition and a film thickness.

In the phase shift film 12, in an element ratio of the entire phase shift film 12, the content of silicon is preferably in a range of 20 at% or more and 60 at% or less, the content of the transition metal is preferably in a range of 0 at% or more and 20 at% or less, the content of nitrogen is preferably in a range of 30 at% or more and 80 at% or less, the content of oxygen is preferably in a range of 0 at% or more and 30 at% or less, and the content of carbon is preferably in a range of 0 at% or more and 10 at% or less. As a more preferable range of the content of each of the elements in the phase shift film 12, in the element ratio of the entire phase shift film 12, the content of silicon is in a range of 30 at% or more and 50 at% or less, the content of the transition metal is in a range of 0 at% or more and 10 at% or less, the content of nitrogen is in a range of 40 at% or more and 70 at% or less, the content of oxygen is in a range of 0 at% or more and 20 at% or less, and the content of carbon is in a range of 0 at% or more and 5 at% or less. In a case where the content of each element in the phase shift film 12 is in the above-described numerical range, the phase difference can also be easily controlled together with the transmittance of the phase shift film 12.

The phase shift film 12 may contain at least one of an oxide, a carbide, or a nitride of a metal silicide. In this case, a metal configuring the metal silicide may be the above-described transition metal.

The transition metal contained in the phase shift film 12 is preferably at least one selected from molybdenum, titanium, vanadium, cobalt, nickel, zirconium, niobium, tantalum, and tungsten and is more preferably molybdenum. In a case where the transition metal contained in the phase shift film 12 is at least one selected from molybdenum, titanium, vanadium, cobalt, nickel, zirconium, niobium, tantalum, or tungsten, the phase shift film 12 is easily processed, and in a case where the transition metal is molybdenum, the workability of the phase shift film 12, such as etching, is further improved.

### (Overall Configuration of Phase Shift Mask)

Hereinafter, a configuration of a phase shift mask 100 according to the embodiment of the present invention will be described.

FIG. 2A is a schematic cross-sectional view illustrating a configuration of a phase shift mask according to the embodiment of the present invention. In addition, FIG. 2B is an enlarged schematic cross-sectional view of a part of the configuration of the phase shift mask according to the embodiment of the present invention. The phase shift mask 100 illustrated in FIGS. 2A and 2B is a phase shift mask having a circuit pattern by application of exposure light having a wavelength of 200 nm or less (that is, a patterned phase shift mask), the phase shift mask including the substrate 11 that is transparent with respect to the exposure wavelength, the phase shift film 12 that is formed on the substrate 11 and has a circuit pattern, and a gas permeation protective film (hereinafter, also simply referred to as a "protective film") 13 that is formed to cover at least an upper surface 12t and a side surface 12s of the phase shift film 12. In addition, the phase shift film 12 has a function of enabling adjustment of each of the phase and the transmittance with respect to exposure light to be transmitted to a predetermined extent. In addition, the protective film 13 has a function of preventing gas permeation into the phase shift film 12. In addition, in a case where the film thickness of the phase shift film 12 is denoted by d1 and the film thickness of the protective film 13 is denoted by d2, d1 is thicker than d2, and d2 is 15 nm or less.

The phase shift mask 100 includes a phase shift film pattern 12a formed by removing a part of the phase shift film 12 configuring the phase shift mask blank 10 to expose the surface of the substrate 11 (phase shift film 12 having a circuit pattern).

The compositions and the like of the substrate 11 and the phase shift film 12 having a circuit pattern configuring the phase shift mask 100 according to the embodiment of the present invention are the same as the compositions and the like of the substrate 11 and the phase shift film 12 configuring the above-described phase shift mask blank 10 according to the embodiment of the present invention. Therefore, detailed descriptions regarding the compositions and the like of the substrate 11 and the phase shift film 12 having a circuit pattern will be omitted.

Hereinafter, the protective film 13, which is a portion different from the phase shift mask blank 10, in the phase shift mask 100 will be described in detail.

### (Protective Film)

The protective film 13 is formed on the phase shift film 12 with or without another film therebetween, and is a layer for preventing or suppressing gas permeation (particularly, permeation of water or an oxidative gas such as oxygen) into the phase shift film 12, that is, a gas barrier layer. In the present embodiment, since the intrusion of a gas, which is considered as one of the elements causing the occurrence of haze, into the phase shift film 12 can be prevented or suppressed, the occurrence of haze on the surface of the phase shift mask can be prevented or suppressed even in a case where the mask is used for a long period of time (for example, in a case where the dosage on the mask exceeds 100 kJ/cm²).

The gas (atmosphere gas), permeation of which is prevented or suppressed by the protective film 13, is an oxidative gas, specifically, an oxygen-containing molecule, and more specifically, a water molecule.

The protective film 13 may have a refractive index n in a range of 1.2 or more and 2.6 or less with respect to exposure light and an attenuation coefficient k in a range of 0.0 or more and 0.4 or less. The protective film 13 satisfying the above-described conditions has both a function as a gas barrier layer and a function (effect) of suppressing an increase in surface reflectivity. Further, in a case where the protective film 13 satisfies the above-described conditions, it is possible to suppress an increase in reflectivity on the phase shift mask surface, and it is possible to reduce the deterioration of the exposure performance due to flare. Here, the "flare" refers to a phenomenon in which exposure light is diffusely reflected from an inner wall surface or the like of an exposure apparatus.

The protective film 13 is preferably a single-layer film that contains at least one selected from a hafnium metal or a hafnium compound or a mixed film or a multi-layer film of these compounds, but the composition is not particularly limited as long as the protective film is a layer having a barrier function. In addition, the hafnium compound is preferably a compound containing hafnium and containing at least one selected from nitrogen, oxygen, carbon, or fluorine. The above-described hafnium metal means a simple substance of a metal.

The protective film 13 including the hafnium compound is a single-layer film that contains hafnium and one or more elements selected from oxygen, nitrogen, carbon, and fluorine or is a multi-layer film or a graded film thereof.

In the protective film 13 including the hafnium compound, in an element ratio of the entire protective film 13, the content of hafnium is preferably in a range of 10 at% or more and 70 at% or less, the content of oxygen is preferably in a range of 10 at% or more and 90 at% or less, the content of nitrogen is preferably in a range of 10 at% or more and 70 at% or less, the content of carbon is preferably in a range of 10 at% or more and 70 at% or less, and the content of fluorine is preferably in a range of 10 at% or more and 90 at% or less. As a more preferable range of the content of each of the elements in the protective film 13 including the hafnium compound, in the element ratio of the entire protective film 13, the content of hafnium is in a range of 10 at% or more and 60 at% or less, the content of oxygen is in a range of 60 at% or more and 80 at% or less, the content of nitrogen is in a range of 40 at% or more and 60 at% or less, the content of carbon is in a range of 40 at% or more and 60 at% or less, and the content of fluorine is in a range of 70 at% or more and 90 at% or less. In a case where the content of each element in the protective film 13 including the hafnium compound is within the above-described numerical range, the barrier property of the protective film 13 to the gas permeation to the phase shift film 12 is enhanced.

In addition, the protective film 13 may be a single-layer film that contains silicon and one or more elements selected from oxygen, nitrogen, and carbon or a multi-layer film or a graded film thereof.

In the protective film 13 including the compound containing silicon (silicon-containing compound), in an element ratio of the entire protective film 13, the content of silicon is preferably in a range of 10 at% or more and 70 at% or less, the content of oxygen is preferably in a range of 10 at% or more and 90 at% or less, the content of nitrogen is preferably in a range of 10 at% or more and 80 at% or less, and the content of carbon is preferably in a range of 10 at% or more and 70 at% or less. As a more preferable range of the content of each of the elements in the protective film 13 including the silicon-containing compound, in the element ratio of the entire protective film 13, the content of silicon is in a range of 20 at% or more and 60 at% or less, the content of oxygen is in a range of 60 at% or more and 80 at% or less, the content of nitrogen is in a range of 50 at% or more and 70 at% or less, and the content of carbon is in a range of 40 at% or more and 60 at% or less. In a case where the content of each element in the protective film 13 including the silicon-containing compound is within the above-described numerical range, the barrier property of the protective film 13 to the gas permeation to the phase shift film 12 is enhanced.

In addition, the protective film 13 may be a single-layer film that contains aluminum and one or more elements selected from oxygen, nitrogen, and carbon or a multi-layer film or a graded film thereof.

In the protective film 13 including the compound containing aluminum (aluminum-containing compound), in an element ratio of the entire protective film 13, the content of aluminum is preferably in a range of 10 at% or more and 80 at% or less, the content of oxygen is preferably in a range of 10 at% or more and 80 at% or less, the content of nitrogen is preferably in a range of 10 at% or more and 70 at% or less, and the content of carbon is preferably in a range of 10 at% or more and 60 at% or less. As a more preferable range of the content of each of the elements in the protective film 13 including the aluminum-containing compound, in the element ratio of the entire protective film 13, the content of aluminum is in a range of 30 at% or more and 70 at% or less, the content of oxygen is in a range of 50 at% or more and 70 at% or less, the content of nitrogen is in a range of 40 at% or more and 60 at% or less, and the content of carbon is in a range of 30 at% or more and 50 at% or less. In a case where the content of each element in the protective film 13 including the aluminum-containing compound is within the above-described numerical range, the barrier property of the protective film 13 to the gas permeation to the phase shift film 12 is enhanced.

As described above, in a case where the protective film 13 is a film in which the composition of the protective film 13 is adjusted such that the refractive index n with respect to exposure light is in a range of 1.2 or more and 2.6 or less and the attenuation coefficient k is in a range of 0.0 or more and 0.4 or less, the effect of suppressing an increase in surface reflectivity is enhanced. Specifically, in a case where the protective film 13 is a single-layer film including one or more substances (elements) selected from a hafnium metal, a hafnium compound, silicon, and aluminum or a mixed film or a multi-layer film of these compounds, the effect of suppressing an increase in surface reflectivity is further enhanced.

In a case where the film thickness of the phase shift film 12 is denoted by d1 and the film thickness of the protective film 13 is denoted by d2, the film thickness d1 of the phase shift film 12 is thicker than the film thickness d2 of the protective film 13, and the film thickness d2 of the protective film 13 is 15 nm or less. In addition, the film thickness d2 of the protective film 13 is preferably 1 nm or more. In a case where the film thickness d2 of the protective film 13 is within the above-described numerical range, the barrier property to the gas permeation into the phase shift film 12 can also be maintained while maintaining the optical characteristics. When the film thickness d2 of the protective film 13 has been made to be thicker than 15 nm, there may be an influence on optical characteristics.

In addition, the film thickness d1 of the phase shift film 12 may be thicker than 15 nm. In a case where the film thickness d1 of the phase shift film 12 is thicker than 15 nm, it is easy to adjust each of the phase and the transmittance.

In addition, a total film thickness of the film thickness of the phase shift film 12 and the film thickness of the protective film 13 is preferably 50 nm or more and more preferably 70 nm or more. In a case where the total film thickness of the film thickness of the phase shift film 12 and the film thickness of the protective film 13 is within the above-described numerical range, it becomes easy to set the function of the phase shift mask 100 to a desired value.

In the present embodiment, the film thickness d2 of the protective film 13 means "a film thickness d2t of the protective film 13 formed on the upper surface 12t of the phase shift film 12".

In addition, in the present embodiment, the film thickness d2t of the protective film 13 formed on the upper surface 12t of the phase shift film 12 and a film thickness d2s of the protective film 13 formed on the side surface 12s of the phase shift film 12 may be the same thickness or may be different thicknesses. For example, the ratio (d2t/d2s) of the film thickness d2t of the protective film 13 to the film thickness d2s of the protective film 13 is preferably in a range of 0.2 or more and 2.0 or less, more preferably in a range of 0.5 or more and 1.5 or less, and most preferably 1. In a case where the ratio of the film thickness d2t of the protective film 13 to the film thickness d2s of the protective film 13 is within the above-described numerical range, the protective film 13 more sufficiently functions as a gas barrier layer.

The protective film 13 can be formed by a well-known method. Preferable examples of a method of most easily obtaining a film having excellent homogeneity and excellent uniformity in film thickness include an atomic layer deposition (ALD) method, but the present embodiment is not limited to the atomic layer deposition (ALD) method.

A ratio of the surface reflectivity of the protective film 13 to the surface reflectivity of the phase shift film 12 (the surface reflectivity of the protective film 13/the surface reflectivity of the phase shift film 12) is preferably in a range of 0.40 or more and 1.20 or less, more preferably in a range of 0.40 or more and 0.95 or less, still more preferably in a range of 0.40 or more and 0.80 or less, and even still more preferably in a range of 0.40 or more and 0.70 or less. In a case where the surface reflectivity of the protective film 13 is within the above-described numerical range, it is possible to reduce the deterioration of the exposure performance due to flare.

The surface reflectivity of the phase shift film 12 may be determined, for example, by measuring the relative reflectivity on the surface of the phase shift film 12 using a spectrophotometer. Here, the "relative reflectivity" is a numerical value representing how much the light energy radiated from the spectrophotometer is reflected back from a test surface (the surface of the phase shift film 12) in the unit of "%". That is, as the test surface (the surface of the phase shift film 12) is brighter and has more luster, the value is closer to 100%.

In the present embodiment, the same measurement of surface reflectivity was repeated 10 times for the same sample, and the average value thereof was defined as the "surface reflectivity of the phase shift film 12".

### (Method for Manufacturing Phase Shift Mask)

A method for manufacturing the phase shift mask 100 using the phase shift mask blank 10 according to the present embodiment includes a step of forming the phase shift film 12 on the substrate 11, a step of forming a light shielding film 15 on the phase shift film 12, a step of forming a resist pattern 16 on the light shielding film 15 formed on the phase shift film 12, a step of forming a pattern on the light shielding film 15 by oxygen-containing chlorine-based etching (Cl/O-based) after forming the resist pattern 16, a step of forming a pattern on the phase shift film 12 by fluorine-based etching (F-based) after forming the pattern on the light shielding film 15, a step of removing the resist pattern 16 after forming the pattern on the phase shift film 12, a step of removing the light shielding film 15 from the phase shift film 12 on which the pattern is formed by oxygen-containing chlorine-based etching (Cl/O-based) after removing the resist pattern 16, a step of performing a defect inspection after removing the resist pattern 16 and before removing the light shielding film 15 or after removing the light shielding film 15, a step of correcting the light shielding film 15 or the phase shift film 12 at a defective portion in a case where a defect is detected in the defect inspection, and a step of forming the protective film 13 on the upper surface 12t and the side surface 12s of the phase shift film 12 on which the pattern is formed after correcting the light shielding film 15 or the phase shift film 12 at the defective portion. In addition, in the method for manufacturing the phase shift mask 100 using the phase shift mask blank 10 according to the present embodiment, in a case where a defect is detected in the defect inspection described above, the light shielding film 15 or the phase shift film 12 at the defective portion may be corrected.

Here, the light shielding film 15 according to the embodiment of the present invention will be described.

### (Light Shielding Film)

The light shielding film 15 is a layer formed on the above-described phase shift mask blank 10 (phase shift film 12) according to the embodiment of the present invention.

The light shielding film 15 is, for example, a single-layer film including a chromium simple substance or a chromium compound or is a multi-layer film or a graded film thereof. More specifically, the light shielding film 15 including the chromium compound is a single-layer film that contains chromium and one or more elements selected from nitrogen and oxygen or is a multi-layer film or a graded film thereof.

In the light shielding film 15 including the chromium compound, in an element ratio of the entire light shielding film 15, the content of chromium is preferably in a range of 30 at% or more and 100 at% or less, the content of oxygen is preferably in a range of 0 at% or more and 50 at% or less, the content of nitrogen is preferably in a range of 0 at% or more and 50 at% or less, and the content of carbon is preferably in a range of 0 at% or more and 10 at% or less. As a more preferable range of the content of each of the elements in the light shielding film 15 including the chromium compound, in the element ratio of the entire light shielding film 15, the content of chromium is in a range of 50 at% or more and 100 at% or less, the content of oxygen is in a range of 0 at% or more and 40 at% or less, the content of nitrogen is in a range of 0 at% or more and 40 at% or less, and the content of carbon is in a range of 0 at% or more and 5 at% or less. When the content of each of the elements in the light shielding film 15 including the chromium compound is in the above-described numerical range, the light shielding property of the light shielding film 15 is enhanced.

A film thickness of the light shielding film 15 is, for example, in a range of 15 nm or more and 80 nm or less and particularly preferably in a range of 20 nm or more and 75 nm or less.

The light shielding film 15 can be formed by a well-known method. Preferable examples of a method of most easily obtaining a film having excellent homogeneity include a sputtering film formation method. The present embodiment is not limited to the sputtering film formation method.

A target and a sputtering gas are selected depending on the film composition. For example, as a method of forming a film containing chromium, a method of performing reactive sputtering using a target containing chromium in only an inert gas such as an argon gas, in only a reactive gas such as oxygen, or in a mixed gas of an inert gas and a reactive gas can be performed. The flow rate of the sputtering gas may be adjusted depending on film characteristics, may be uniform during film forming, or when the oxygen content or the nitrogen content is desired to change in a film thickness direction, may be changed depending on a target composition. In addition, power applied to the target, a distance between the target and the substrate, or an internal pressure of a film forming chamber may be adjusted.

Hereinafter, each of the steps in the method for manufacturing the phase shift mask 100 according to the embodiment of the present invention will be described.

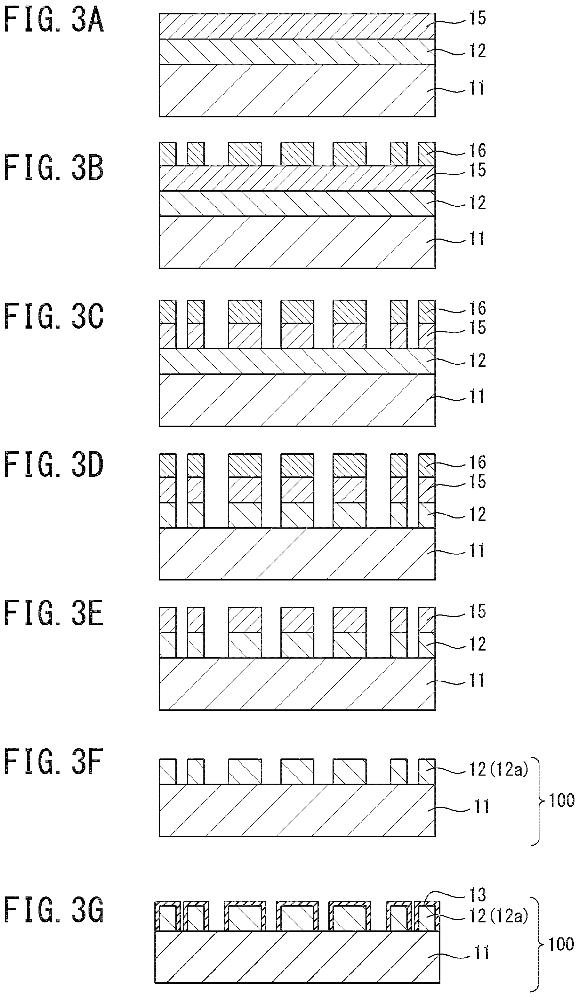

FIGS. 3A to 3G are schematic cross-sectional views illustrating steps of manufacturing the phase shift mask 100 using the phase shift mask blank 10 illustrated in FIG. 1. FIG. 3A illustrates a step of forming the light shielding film 15 on the phase shift film 12. FIG. 3B illustrates a step of forming the resist pattern 16 by applying a resist film to the light shielding film 15, drawing a pattern, and developing the pattern. FIG. 3C illustrates a step of patterning the light shielding film 15 along the resist pattern 16 by oxygen-containing chlorine-based dry etching (Cl/O-based). FIG. 3D illustrates a step of forming the phase shift film pattern 12a by patterning the phase shift film 12 along the pattern of the light shielding film 15 by fluorine-based etching (F-based). FIG. 3E illustrates a step of peeling and removing the resist pattern 16 and cleaning the mask. FIG. 3F illustrates a step of removing the light shielding film 15 by oxygen-containing chlorine-based etching (Cl/O-based) from the phase shift film 12 (phase shift film pattern 12a) on which the pattern is formed. FIG. 3G illustrates a step of forming the protective film 13 on the upper surface 12t and the side surface 12s of the phase shift film 12 on which the pattern is formed (phase shift film pattern 12a) after the light shielding film 15 is removed. This way, the phase shift mask 100 according to the present embodiment is manufactured.

In the present manufacturing step, a step of performing a defect inspection after the resist pattern 16 is removed and before the light shielding film 15 is removed, or after the light shielding film 15 is removed is included. In a case where a defect is detected in the defect inspection, the phase shift mask 100 according to the present embodiment is manufactured by correcting the light shielding film 15 or the phase shift film 12 at the defective portion.

The phase shift mask 100 according to the present embodiment manufactured as described above is a phase shift mask to which exposure light having a wavelength of 200 nm or less is applied and includes the substrate 11, the phase shift film 12 formed on the substrate 11 with or without another film therebetween, and the protective film 13 formed on the upper surface 12t and the side surface 12s of the phase shift film 12 (phase shift film pattern 12a). In addition, the phase shift film 12 having a circuit pattern has a function of enabling adjustment of each of the phase and the transmittance with respect to the exposure light to be transmitted to a predetermined extent. In addition, the protective film 13 has a function of preventing gas permeation into the phase shift film 12.

In addition, the phase shift mask 100 includes the phase shift film pattern 12a that is formed by removing a part of the phase shift film 12 to expose a part of the substrate 11. In a case where the film thickness of the phase shift film 12 is denoted by d1 and the film thickness of the protective film 13 is denoted by d2, the film thickness d1 of the phase shift film 12 is thicker than the film thickness d2 of the protective film 13, and the film thickness d2 of the protective film 13 is 15 nm or less.

In the step of FIG. 3B, as a material of the resist film, a positive resist or a negative resist can also be used. However, a chemically amplified resist for electron beam drawing capable of forming a high accuracy pattern is preferably used. A film thickness of the resist film is, for example, in a range of 50 nm or more and 250 nm or less. In particular, in the case of producing a phase shift mask in which nanopattern formation is required, in order to prevent pattern collapse, it is necessary to reduce the film thickness of the resist film so that the aspect ratio of the resist pattern 16 does not increase, and the film thickness is preferably 200 nm or less. On the other hand, the lower limit of the film thickness of the resist film is determined in comprehensive consideration of conditions such as the etching resistance of the resist material to be used and is preferably 60 nm or more. When a chemically amplified resist for electron beam drawing is used as the resist film, an energy density of an electron beam during drawing is in a range of 35 µC/cm² to 100 µC/cm², and by performing a heat treatment and a development treatment after the drawing, the resist pattern 16 is obtained.

In addition, in the step of FIG. 3E, the peeling and removal of the resist pattern 16 may be wet peeling using a peeling solution or may be dry peeling by dry etching.

In addition, in the step of FIG. 3C, the conditions of the oxygen-containing chlorine-based dry etching (Cl/O-based) for patterning the light shielding film 15 including a chromium simple substance or a chromium compound may be well-known conditions that have been used for removing a chromium compound film, and the chlorine gas and the oxygen gas may be mixed with an inert gas such as a nitrogen gas or a helium gas as necessary. The phase shift film 12 as the lower layer has resistance to oxygen-containing chlorine-based dry etching (Cl/O-based), and thus remains without being removed or patterned in the present step.

In addition, in the step of FIG. 3D, the conditions of the fluorine-based dry etching (F-based) for patterning the phase shift film 12 may be well-known conditions that have been used in the case of dry etching a silicon-based compound film, a tantalum compound film, a molybdenum compound film, or the like, CF₄, C₂F₆, or SF₆ is generally used as the fluorine-based gas, and an active gas such as oxygen or an inert gas such as a nitrogen gas or a helium gas may be mixed as necessary. In the case of FIG. 3D, the light shielding film 15 or the resist pattern 16 as the upper layer has resistance to fluorine-based dry etching (F-based), and thus remains without being removed or patterned in the present step. In FIG. 3D, it is general to dig the substrate 11 by about 1 nm to 3 nm to prevent poor removal of the phase shift film 12 and finely adjust the phase difference at the same time.

In addition, in the step of FIG. 3F, the conditions of the oxygen-containing chlorine-based dry etching (Cl/O-based) for removing the light shielding film 15 may be well-known conditions that have been used for removing the chromium compound film, and the chlorine gas and the oxygen gas may be mixed with an inert gas such as a nitrogen gas or a helium gas as necessary. Both the phase shift film 12 and the substrate 11 as the lower layers have resistance to oxygen-containing chlorine-based dry etching (Cl/O-based), and thus remain without being removed or patterned in the present step.

### (Other Embodiments)

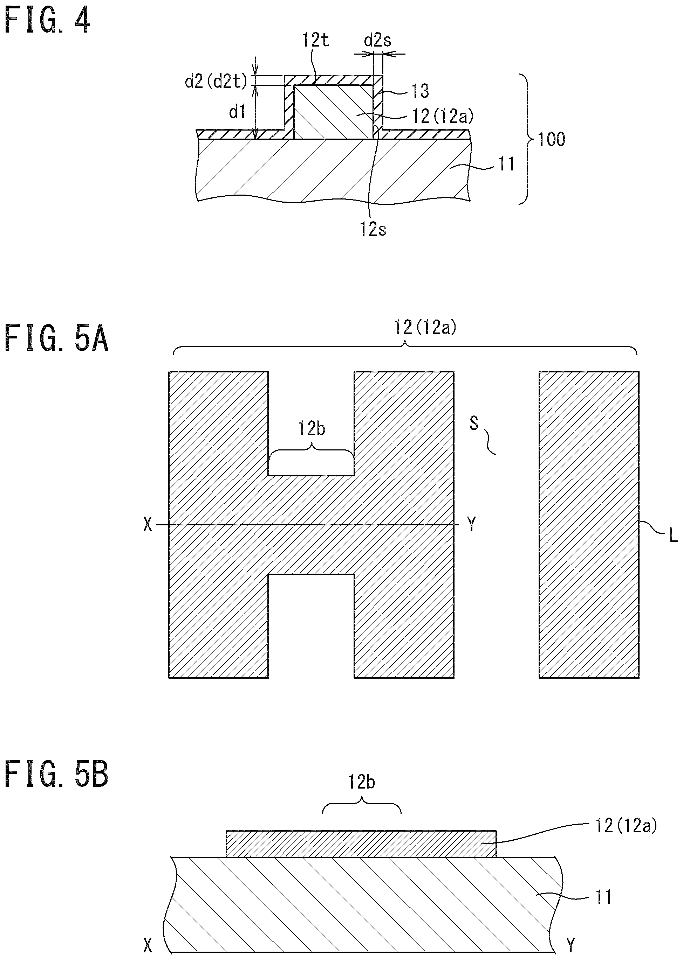

In the present embodiment, although the case where the protective film 13 is formed on the upper surface 12t and the side surface 12s of the phase shift film 12 (phase shift film pattern 12a) has been described, the present invention is not limited thereto. For example, as illustrated in FIG. 4, the protective film 13 may be formed on the upper surface 12t and the side surface 12s of the phase shift film 12 and on the exposed substrate 11. In the above-described aspect, since the substrate exposure portion is a reference for both the phase difference and the transmittance, and the portion where the pattern is formed causes a phase change/transmittance change, the adjustment of the phase difference and the transmittance is not necessary (easy).

In addition, the composition of the protective film 13 formed on the substrate 11 may be the same as the composition of the protective film 13 formed on the upper surface 12t and the side surface 12s of the phase shift film 12.

In addition, there may be no interface between the protective film 13 formed on the substrate 11 and the protective film 13 formed on the upper surface 12t and the side surface 12s of the phase shift film 12, and the protective films 13 may be continuous films.

In addition, the case where the protective film 13 is a single layer has been described in the present embodiment, but the present invention is not limited thereto. For example, the protective film 13 may be multilayer (multi-layer film). In this case, the density of the film positioned on the surface side of the protective film 13 may be higher than the density of the film positioned on the phase shift film 12 side of the protective film 13.

In the present embodiment, although the case of forming the protective film 13 on the upper surface 12t and the side surface 12s of the phase shift film 12 (phase shift film pattern 12a) has been described, the present invention is not limited thereto. For example, in the step of forming the protective film 13, the protective film 13 may be formed on the upper surface 12t and the side surface 12s of the phase shift film 12 and on the exposed substrate 11. In the above-described aspect, since the substrate exposure portion is a reference for both the phase difference and the transmittance, and the portion where the pattern is formed causes a phase change/transmittance change, the adjustment of the phase difference and the transmittance is not necessary (easy).

In addition, the composition of the protective film 13 formed on the substrate 11 may be formed to be the same as the composition of the protective film 13 formed on the upper surface 12t and the side surface 12s of the phase shift film 12.

In addition, a continuous film (protective film 13) in which there is no interface between the protective film 13 formed on the substrate 11 and the protective film 13 formed on the upper surface 12t and the side surface 12s of the phase shift film 12 may be formed.

In addition, in the present embodiment, the case of forming the single-layer protective film 13 has been described, but the present invention is not limited thereto. For example, the protective film 13 may be formed to be multilayer (multi-layer film). In this case, the film positioned on the surface side of the protective film 13 may be formed such that the density of the film is higher than the density of the film positioned on the phase shift film 12 side of the protective film 13.

### [Example]

Hereinafter, the embodiments of the present invention will be more specifically described using examples. However, the present invention is not limited to the following examples.

### (Example 1)

Using a DC sputtering apparatus in which two targets were used, a phase shift film including silicon, molybdenum, oxygen, and nitrogen and having a thickness of 70 nm was formed on a quartz substrate. Molybdenum and silicon were used as the targets, and argon, oxygen, and nitrogen were used as a sputtering gas. In a case where the composition of this phase shift film was analyzed by ESCA, Si:Mo:O:N was 40:8:7:45 (at% ratio).

The phase shift film formed in this manner had a transmittance of exposure light of 6% and a phase difference of 180 degrees. In the present example, the "transmittance of exposure light" means the transmittance of exposure light in a non-opening portion with respect to an opening portion of the phase shift film. In addition, the "phase difference" means a phase difference between the opening portion and the non-opening portion of the phase shift film.

Next, a light shielding film including chromium, oxygen, and nitrogen was formed on the phase shift film to a thickness of 50 nm using the DC sputtering apparatus. Chromium was used as a target, and argon, oxygen, and nitrogen were used as a sputtering gas. In a case where the composition of this light shielding film was analyzed by ESCA, Cr:O:N was 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was thermally treated at 110°C for 10 minutes, and was developed by puddle development for 90 seconds to form a resist pattern.

Next, the light shielding film was patterned using a dry etching apparatus. Chlorine, oxygen, and helium were used as an etching gas, the gas pressure was set to 5 mTorr, the ICP power was set to 400 W, and the bias power was set to 40 W. Overetching was performed by 100%.

Next, the phase shift film was patterned using the dry etching apparatus. CF₄ and oxygen were used as an etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, the light shielding film was removed using the dry etching apparatus. Chlorine, oxygen, and helium were used as an etching gas, the gas pressure was set to 10 mTorr, the ICP power was set to 500 W, and the bias power was set to 10 W. Overetching was performed by 200%. In this case, no damage occurred in the phase shift film and the quartz substrate as the lower layers.

Next, the phase shift mask was subjected to electron beam correction. Hereinafter, a method of the electron beam correction will be described.

### (Correction Method)

A method of correcting the phase shift mask 100 will be simply described using FIGS. 5A to 7B. It should be noted that, here, a case where the defect inspection is performed and then the correction is performed after removing the light shielding film 15 will be described, but the defect inspection may be performed and then the correction may be performed after removing the resist pattern 16 and before removing the light shielding film 15.

FIGS. 5A and 5B illustrate enlarged views of a part of the phase shift film 12 (phase shift film pattern 12a) in the phase shift mask 100. More specifically, FIG. 5A is a schematic plan view illustrating a structure before the correction step of the phase shift mask 100 according to the present example, and FIG. 5B is a schematic cross-sectional view illustrating the structure before the correction step of the phase shift mask 100 according to the present example.

In FIG. 5A, "L" indicates a region where the phase shift film 12 is formed, and "S" indicates a region where the substrate 11 is exposed. In addition, in FIGS. 5A and 5B, "12b" indicates a correction portion.

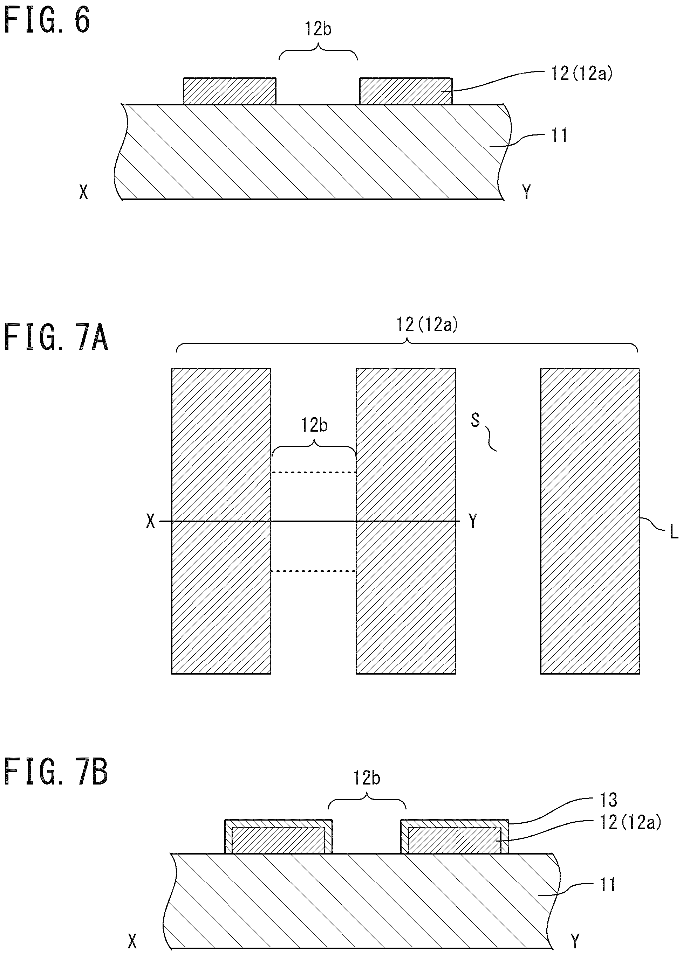

As illustrated in FIG. 6, the phase shift film 12 (phase shift film pattern 12a) after the removal of the light shielding film 15 was corrected.

This way, a phase shift mask 100 in which the phase shift film 12 was corrected was obtained.

Finally, as illustrated in FIG. 7A and 7B, protective films were formed on the upper surface and the side surface of the phase shift film (phase shift film after correction) and on the exposed quartz substrate. In the formation of the protective films, tetrakisdimethylaminohafnium (Hf(N(CH₃)₂)₄) as a precursor and a fluorine-based precursor were reacted with each other by a thermal ALD method 63 cycles to form 5 nm hafnium fluoride (HfF₄).

This way, a phase shift mask according to Example 1 was obtained.

Next, regarding the phase shift mask, a dosage at which haze had occurred by accelerated exposure was measured and was 128 kJ/cm².

Regarding "the dosage at which haze had occurred by accelerated exposure", as the value increases, haze is less likely to occur. It can be said that, in a case where the dosage is 70 kJ/cm² or more (evaluated as "Δ" in the following table), there are no problems in using the phase shift mask, and in a case where the dosage is 100 kJ/cm² or more (evaluated as "o" in the following table), haze is less likely to occur in the phase shift mask. In addition, it can be said that, in a case where the dosage is 110 kJ/cm² or more (evaluated as "⊚" in the following table), haze is extremely less likely to occur in the phase shift mask. In a case where the dosage is less than 70 kJ/cm² (evaluated as "×" in the following table), the probability of the occurrence of haze is substantially the same as those of phase shift masks according to the related art.

It was confirmed from the above-described measurement result, in the phase shift mask according to Example 1, the dosage was 128 kJ/cm², and thus the occurrence of haze could be reduced.

Next, in a case where the surface reflectivity was measured with respect to this phase shift mask, the surface reflectivity was 17.1%. In addition, in a case where a ratio of the surface reflectivity of the phase shift mask of Example 1 to the surface reflectivity of the phase shift mask of Comparative Example 1, which will be described later, (surface reflectivity of phase shift mask of Example 1/surface reflectivity of phase shift mask of Comparative Example 1: relative ratio) was calculated, the value thereof was 0.78.

It means that the smaller the value of the "relative ratio", the less likely flare occurs. It can be said that, in a case where the relative ratio is 0.95 or less (evaluated as "Δ" in the following table), there are no problems in using the phase shift mask, and in a case where the relative ratio is 0.80 or less (evaluated as "o" in the following table), flare is less likely to occur in the phase shift mask. In addition, it can be said that, in a case where the relative ratio is 0.70 or less (evaluated as "⊚" in the following table), flare is extremely less likely to occur in the phase shift mask. It can be said that, in a case where the relative ratio is more than 1.0, the occurrence of flare is not reduced in the phase shift mask (evaluated as "×" in the following table).

### (Example 2)

Using a DC sputtering apparatus in which two targets were used, a phase shift film including silicon, molybdenum, oxygen, and nitrogen and having a thickness of 70 nm was formed on a quartz substrate. Molybdenum and silicon were used as the targets, and argon, oxygen, and nitrogen were used as a sputtering gas. In a case where the composition of this phase shift film was analyzed by ESCA, Si:Mo:O:N was 40:8:7:45 (at% ratio).

The phase shift film formed in this manner had a transmittance of exposure light of 6% and a phase difference of 180 degrees.

Next, a light shielding film including chromium, oxygen, and nitrogen was formed on the phase shift film to a thickness of 50 nm using the DC sputtering apparatus. Chromium was used as a target, and argon, oxygen, and nitrogen were used as a sputtering gas. In a case where the composition of this light shielding film was analyzed by ESCA, Cr:O:N was 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was thermally treated at 110°C for 10 minutes, and was developed by puddle development for 90 seconds to form a resist pattern.

Next, the light shielding film was patterned using a dry etching apparatus. Chlorine, oxygen, and helium were used as an etching gas, the gas pressure was set to 5 mTorr, the ICP power was set to 400 W, and the bias power was set to 40 W. Overetching was performed by 100%.

Next, the phase shift film was patterned using the dry etching apparatus. CF₄ and oxygen were used as an etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, the light shielding film was removed using the dry etching apparatus. Chlorine, oxygen, and helium were used as an etching gas, the gas pressure was set to 10 mTorr, the ICP power was set to 500 W, and the bias power was set to 10 W. Overetching was performed by 200%. In this case, no damage occurred in the phase shift film and the quartz substrate as the lower layers.

Next, the phase shift mask was corrected using the same method as in Example 1.

Finally, protective films were formed on the upper surface and the side surface of the phase shift film and on the exposed quartz substrate. In the formation of the protective films, tetrakisdimethylaminohafnium (Hf(N(CH₃)₂)₄) as a precursor and O₂ plasma were reacted with each other by a plasma ALD method 130 cycles to form 13 nm hafnium oxide (HfO₂).

This way, a phase shift mask according to Example 2 was obtained.

Next, regarding the phase shift mask, a dosage at which haze had occurred by accelerated exposure was measured and was 163 kJ/cm² or more.

It was confirmed from the above-described result that, in the phase shift mask according to Example 2, the dosage was 163 kJ/cm² or more, and thus the occurrence of haze could be reduced.

Next, in a case where the surface reflectivity was measured with respect to this phase shift mask, the surface reflectivity was 17.5%. In addition, in a case where a ratio of the surface reflectivity of the phase shift mask of Example 2 to the surface reflectivity of the phase shift mask of Comparative Example 1, which will be described later, (surface reflectivity of phase shift mask of Example 2/surface reflectivity of phase shift mask of Comparative Example 1: relative ratio) was calculated, the value thereof was 0.80.

It was confirmed from the above-described result that, in a case of the phase shift mask according to Example 2, the relative ratio was 0.80, and thus the occurrence of flare could be reduced.

### (Example 3)

Using a DC sputtering apparatus in which two targets were used, a phase shift film including silicon, molybdenum, oxygen, and nitrogen and having a thickness of 70 nm was formed on a quartz substrate. Molybdenum and silicon were used as the targets, and argon, oxygen, and nitrogen were used as a sputtering gas. In a case where the composition of this phase shift film was analyzed by ESCA, Si:Mo:O:N was 40:8:7:45 (at% ratio).

The phase shift film formed in this manner had a transmittance of exposure light of 6% and a phase difference of 180 degrees.

Next, a light shielding film including chromium, oxygen, and nitrogen was formed on the phase shift film to a thickness of 50 nm using the DC sputtering apparatus. Chromium was used as a target, and argon, oxygen, and nitrogen were used as a sputtering gas. In a case where the composition of this light shielding film was analyzed by ESCA, Cr:O:N was 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was thermally treated at 110°C for 10 minutes, and was developed by puddle development for 90 seconds to form a resist pattern.

Next, the light shielding film was patterned using a dry etching apparatus. Chlorine, oxygen, and helium were used as an etching gas, the gas pressure was set to 5 mTorr, the ICP power was set to 400 W, and the bias power was set to 40 W. Overetching was performed by 100%.

Next, the phase shift film was patterned using the dry etching apparatus. CF₄ and oxygen were used as an etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, the light shielding film was removed using the dry etching apparatus. Chlorine, oxygen, and helium were used as an etching gas, the gas pressure was set to 10 mTorr, the ICP power was set to 500 W, and the bias power was set to 10 W. Overetching was performed by 200%. In this case, no damage occurred in the phase shift film and the quartz substrate as the lower layers.

Next, the phase shift mask was corrected using the same method as in Example 1.

Finally, protective films were formed on the upper surface and the side surface of the phase shift film and on the exposed quartz substrate. In the formation of the protective films, bisdiethylaminosilane (Si[N(C₂H₅)₂]₂H₂) as a precursor and O₂ plasma were reacted with each other by a plasma ALD method 32 cycles to form 5 nm silicon oxide (SiO₂).

This way, a phase shift mask according to Example 3 was obtained.

Next, regarding the phase shift mask, a dosage at which haze had occurred by accelerated exposure was measured and was 112 kJ/cm².

It was confirmed from the above-described result, in the phase shift mask according to Example 3, the dosage was 112 kJ/cm², and thus the occurrence of haze could be reduced.

Next, in a case where the surface reflectivity was measured with respect to this phase shift mask, the surface reflectivity was 20.0%. In addition, in a case where a ratio of the surface reflectivity of the phase shift mask of Example 3 to the surface reflectivity of the phase shift mask of Comparative Example 1, which will be described later, (surface reflectivity of phase shift mask of Example 3/surface reflectivity of phase shift mask of Comparative Example 1: relative ratio) was calculated, the value thereof was 0.91.

It was confirmed from the above-described result that, in a case of the phase shift mask according to Example 3, the relative ratio was 0.91, and thus the occurrence of flare could be reduced.

### (Example 4)

Using a DC sputtering apparatus in which two targets were used, a phase shift film including silicon, molybdenum, oxygen, and nitrogen and having a thickness of 70 nm was formed on a quartz substrate. Molybdenum and silicon were used as the targets, and argon, oxygen, and nitrogen were used as a sputtering gas. In a case where the composition of this phase shift film was analyzed by ESCA, Si:Mo:O:N was 40:8:7:45 (at% ratio).

The phase shift film formed in this manner had a transmittance of exposure light of 6% and a phase difference of 180 degrees.

Next, a light shielding film including chromium, oxygen, and nitrogen was formed on the phase shift film to a thickness of 50 nm using the DC sputtering apparatus. Chromium was used as a target, and argon, oxygen, and nitrogen were used as a sputtering gas. In a case where the composition of this light shielding film was analyzed by ESCA, Cr:O:N was 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was thermally treated at 110°C for 10 minutes, and was developed by puddle development for 90 seconds to form a resist pattern.

Next, the light shielding film was patterned using a dry etching apparatus. Chlorine, oxygen, and helium were used as an etching gas, the gas pressure was set to 5 mTorr, the ICP power was set to 400 W, and the bias power was set to 40 W. Overetching was performed by 100%.

Next, the phase shift film was patterned using the dry etching apparatus. CF₄ and oxygen were used as an etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, the light shielding film was removed using the dry etching apparatus. Chlorine, oxygen, and helium were used as an etching gas, the gas pressure was set to 10 mTorr, the ICP power was set to 500 W, and the bias power was set to 10 W. Overetching was performed by 200%. In this case, no damage occurred in the phase shift film and the quartz substrate as the lower layers.

Next, the phase shift mask was corrected using the same method as in Example 1.

Finally, protective films were formed on the upper surface and the side surface of the phase shift film and on the exposed quartz substrate. In the formation of the protective films, trimethylaluminum (TMA) as a precursor (Al(CH₃)₃) and O₂ plasma were reacted with each other by a plasma ALD method 36 cycles to form 5 nm aluminum oxide (Al₂O₃).

This way, a phase shift mask according to Example 4 was obtained.

Next, regarding the phase shift mask, a dosage at which haze had occurred by accelerated exposure was measured and was 116 kJ/cm².

It was confirmed from the above-described result, in the phase shift mask according to Example 4, the dosage was 116 kJ/cm², and thus the occurrence of haze could be reduced.

Next, in a case where the surface reflectivity was measured with respect to this phase shift mask, the surface reflectivity was 14.4%. In addition, in a case where a ratio of the surface reflectivity of the phase shift mask of Example 4 to the surface reflectivity of the phase shift mask of Comparative Example 1, which will be described later, (surface reflectivity of phase shift mask of Example 4/surface reflectivity of phase shift mask of Comparative Example 1: relative ratio) was calculated, the value thereof was 0.65.

It was confirmed from the above-described result that, in a case of the phase shift mask according to Example 4, the relative ratio was 0.65, and thus the occurrence of flare could be reduced.

### (Comparative Example 1)

Using a DC sputtering apparatus in which two targets were used, a phase shift film including silicon, molybdenum, oxygen, and nitrogen and having a thickness of 70 nm was formed on a quartz substrate. Molybdenum and silicon were used as the targets, and argon, oxygen, and nitrogen were used as a sputtering gas. In a case where the composition of this phase shift film was analyzed by ESCA, Si:Mo:O:N was 40:8:7:45 (at% ratio).

The phase shift film formed in this manner had a transmittance of exposure light of 6% and a phase difference of 180 degrees.

Next, a light shielding film including chromium, oxygen, and nitrogen was formed on the phase shift film to a thickness of 50 nm using the DC sputtering apparatus. Chromium was used as a target, and argon, oxygen, and nitrogen were used as a sputtering gas. In a case where the composition of this light shielding film was analyzed by ESCA, Cr:O:N was 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was thermally treated at 110°C for 10 minutes, and was developed by puddle development for 90 seconds to form a resist pattern.

Next, the light shielding film was patterned using a dry etching apparatus. Chlorine, oxygen, and helium were used as an etching gas, the gas pressure was set to 5 mTorr, the ICP power was set to 400 W, and the bias power was set to 40 W. Overetching was performed by 100%.

Next, the phase shift film was patterned using the dry etching apparatus. CF₄ and oxygen were used as an etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, the light shielding film was removed using the dry etching apparatus. Chlorine, oxygen, and helium were used as an etching gas, the gas pressure was set to 10 mTorr, the ICP power was set to 500 W, and the bias power was set to 10 W. Overetching was performed by 200%. In this case, no damage occurred in the phase shift film and the quartz substrate as the lower layers.

Next, the phase shift mask was corrected using the same method as in Example 1.

This way, a phase shift mask according to Comparative Example 1 was obtained. That is, the phase shift mask according to Comparative Example 1 is a phase shift mask not including the protective films formed in Examples 1 to 4.

Next, regarding the phase shift mask, a dosage at which haze had occurred by accelerated exposure was measured and was 58 kJ/cm².

It was confirmed from the above-described result, in the phase shift mask according to Comparative Example 1, the dosage was 58 kJ/cm², and thus the occurrence of haze cannot be sufficiently reduced.

As described above, it is found that the formation of the protective films on the upper surface and the side surface of the phase shift film is effective for reducing the amount of the occurrence of haze in the phase shift mask.

Next, in a case where the surface reflectivity was measured with respect to this phase shift mask, the surface reflectivity was 22.0%.

### (Comparative Example 2)

Using a DC sputtering apparatus in which two targets were used, a phase shift film including silicon, molybdenum, oxygen, and nitrogen and having a thickness of 70 nm was formed on a quartz substrate. Molybdenum and silicon were used as the targets, and argon, oxygen, and nitrogen were used as a sputtering gas. In a case where the composition of this phase shift film was analyzed by ESCA, Si:Mo:O:N was 40:8:7:45 (at% ratio).

The phase shift film formed in this manner had a transmittance of exposure light of 6% and a phase difference of 180 degrees.

Next, a light shielding film including chromium, oxygen, and nitrogen was formed on the phase shift film to a thickness of 50 nm using the DC sputtering apparatus. Chromium was used as a target, and argon, oxygen, and nitrogen were used as a sputtering gas. In a case where the composition of this light shielding film was analyzed by ESCA, Cr:O:N was 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was thermally treated at 110°C for 10 minutes, and was developed by puddle development for 90 seconds to form a resist pattern.

Next, the light shielding film was patterned using a dry etching apparatus. Chlorine, oxygen, and helium were used as an etching gas, the gas pressure was set to 5 mTorr, the ICP power was set to 400 W, and the bias power was set to 40 W. Overetching was performed by 100%.

Next, the phase shift film was patterned using the dry etching apparatus. CF₄ and oxygen were used as an etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, the light shielding film was removed using the dry etching apparatus. Chlorine, oxygen, and helium were used as an etching gas, the gas pressure was set to 10 mTorr, the ICP power was set to 500 W, and the bias power was set to 10 W. Overetching was performed by 200%. In this case, no damage occurred in the phase shift film and the quartz substrate as the lower layers.

Next, the phase shift mask was corrected using the same method as in Example 1.

Finally, protective films were formed on the upper surface and the side surface of the phase shift film and on the exposed quartz substrate. In the formation of the protective films, pentaethoxytantalum (Ta(OC₂H₅)₅) as a precursor and O₂ plasma were reacted with each other by a plasma ALD method 91 cycles to form 10 nm tantalum oxide (Ta₂O₅).

This way, a phase shift mask according to Comparative Example 2 was obtained.

Next, regarding the phase shift mask, a dosage at which haze had occurred by accelerated exposure was measured and was 159 kJ/cm².

It was confirmed from the above-described result, in the phase shift mask according to Comparative Example 2, the dosage was 159 kJ/cm², and thus the occurrence of haze could be reduced.

Next, in a case where the surface reflectivity was measured with respect to this phase shift mask, the surface reflectivity was 32.5%. In addition, in a case where the ratio of the surface reflectivity of the phase shift mask of Comparative Example 2 to the surface reflectivity of the phase shift mask of Comparative Example 1 (surface reflectivity of phase shift mask of Comparative Example 2/surface reflectivity of phase shift mask of Comparative Example 1: relative ratio) was calculated, the value thereof was 1.48.

It was confirmed from the above-described result that, in a case of the phase shift mask according to Comparative Example 2, the relative ratio was 1.48, and thus the occurrence of flare could not be improved.

**[Table 1]**

| | | Ex. 1 | | Ex. 2 | | Ex. 3 | | Ex. 4 | |
|---|---|---|---|---|---|---|---|---|---|
| Layer | | Phase shift film | Protective film | Phase shift film | Protective film | Phase shift film | Protective film | Phase shift film | Protective film |
| Composition | | MoSiON | HfF4 | MoSiON | HfO2 | MoSiON | SiO2 | MoSiON | Al2O3 |
| Film thickness (nm) | | 70 | 5 | 70 | 13 | 70 | 5 | 70 | 5 |
| Refractive index n, attenuation coefficient k (n, k) of protective film | | - | 1.5, 0.0 | - | 2.3, 0.2 | - | 1.6, 0.0 | - | 1.8, 0.0 |
| Haze resistance | Dosage (kJ/cm2) | 128 | | 163 | | 112 | | 116 | |
| | Evaluation | ⊚ | | ⊚ | | ⊚ | | ⊚ | |
| Surface reflectivity of protective film | Absolute value (%) | - | 17.1 | - | 17.5 | - | 20.0 | - | 14.4 |
| | Relative value with respect to Comparative Example 1 | - | 0.78 | - | 0.80 | - | 0.91 | - | 0.65 |
| | Evaluation | - | ○ | - | ○ | - | Δ | - | ⊚ |

| | | Comp. Ex. 1 | | Comp. Ex. 2 | |
|---|---|---|---|---|---|
| Layer | | Phase shift film | Protective film | Phase shift film | Protective film |
| Composition | | MoSiON | - | MoSiON | Ta2O5 |
| Film thickness (nm) | | 70 | - | 70 | 10 |
| Refractive index n, attenuation coefficient k (n, k) of protective film | | - | - | - | 2.1, 1.2 |
| Haze resistance | Dosage (kJ/cm2) | 58 | | 159 | |
| | Evaluation | × | | ⊚ | |
| Surface reflectivity of protective film | Absolute value (%) | - | 22 | - | 32.5 |
| | Relative value with respect to Comparative Example 1 | - | (Reference value) | - | 1.48 |
| | Evaluation | - | - | - | × |

Hereinabove, the phase shift mask blank of the present invention and the phase shift mask created using the phase shift mask blank have been described with the examples, but the above-described examples are merely examples for carrying out the present invention, and the present invention is not limited thereto. In addition, it is obvious from the above description that modifications of these examples are within the scope of the present invention and various other examples can be adopted within the scope of the present invention.

### Industrial Applicability

In the present invention, since the composition, film thickness, and layer structure of the phase shift mask blank and the manufacturing step and conditions of the phase shift mask using the phase shift mask blank are selected within appropriate ranges, it is possible to provide a phase shift mask in which a nanopattern corresponding to the manufacture of a logic-system device of 28 nm or less or a memory-system device of 30 nm or less is formed with high accuracy.

### Reference Signs List

10 phase shift mask blank
11 substrate that is transparent with respect to exposure wavelength (substrate)
12 phase shift film
12a phase shift film pattern
13 protective film (gas permeation protective film)
15 light shielding film
16 resist pattern
100 phase shift mask
d1 film thickness of phase shift film
d2 film thickness of protective film (gas permeation protective film)

## Claims

1. A phase shift mask having a circuit pattern by application of exposure light having a wavelength of 200 nm or less, the phase shift mask comprising:
a transparent substrate;
a phase shift film that is formed on the transparent substrate and has a circuit pattern; and
a gas permeation protective film that is formed on an upper surface and a side surface of the phase shift film,
wherein the phase shift film enables adjustment of each of phase and transmittance with respect to the exposure light to be transmitted to a predetermined extent,
the gas permeation protective film has a refractive index in a range of 1.2 or more and 2.6 or less with respect to the exposure light and an attenuation coefficient in a range of 0.0 or more and 0.4 or less, and
in a case where a film thickness of the phase shift film is denoted by d1 and a film thickness of the gas permeation protective film is denoted by d2, d2 is thinner than d1, and d2 is 15 nm or less.

2. The phase shift mask according to claim 1,
wherein the gas permeation protective film contains at least one selected from a hafnium metal and a hafnium compound, and
the hafnium compound contains hafnium and contains at least one selected from nitrogen, oxygen, carbon, or fluorine.

3. The phase shift mask according to claim 1,
wherein the gas permeation protective film contains silicon and contains at least one selected from nitrogen, oxygen, or carbon.

4. The phase shift mask according to claim 1,
wherein the gas permeation protective film contains aluminum and contains at least one selected from nitrogen, oxygen, or carbon.

5. The phase shift mask according to any one of claims 1 to 4,
wherein the phase shift film has resistance to oxygen-containing chlorine-based etching and is etchable by fluorine-based etching.

6. The phase shift mask according to any one of claims 1 to 5,
wherein the phase shift film contains silicon and contains at least one selected from a transition metal, nitrogen, oxygen, or carbon, and
the transition metal is at least one selected from molybdenum, titanium, vanadium, cobalt, nickel, zirconium, niobium, tantalum, or tungsten.

7. The phase shift mask according to any one of claims 1 to 6,
wherein a ratio of a surface reflectivity of the gas permeation protective film to a surface reflectivity of the phase shift film is in a range of 0.4 or more and 1.2 or less.

8. The phase shift mask according to any one of claims 1 to 7,
wherein the gas permeation protective film is also formed on the transparent substrate.

9. A method for manufacturing the phase shift mask according to any one of claims 1 to 8, the method comprising:
forming a phase shift film on the transparent substrate;
forming a light shielding film on the phase shift film;
forming a resist pattern on the light shielding film formed on the phase shift film;
forming a pattern on the light shielding film by oxygen-containing chlorine-based etching after forming the resist pattern;
forming a pattern on the phase shift film by fluorine-based etching after forming the pattern on the light shielding film;
removing the resist pattern after forming the pattern on the phase shift film;
removing the light shielding film from the phase shift film on which the pattern is formed by oxygen-containing chlorine-based etching after removing the resist pattern;
performing a defect inspection after removing the resist pattern and before removing the light shielding film or after removing the light shielding film;
correcting the light shielding film or the phase shift film at a defective portion in a case where a defect is detected in the defect inspection; and
forming the gas permeation protective film on an upper surface and a side surface of the phase shift film on which the pattern is formed after the correction.

10. The method for manufacturing the phase shift mask according to claim 9,
wherein, in the forming of the gas permeation protective film, the gas permeation protective film is also formed on the transparent substrate.
